# EUROPEAN PATENT APPLICATION

(11) **EP 2 221 869 A2**
(43) Date of publication of application: **25.08.2010**
(21) Application number: 09009506.8
(22) Date of filing: 22.07.2009
(51) Int. Cl.: H01L 23/538

(54) **Wire bond chip package**

(30) Priority: 20.02.2009 US 154019 P; 17.06.2009 US 485923
(71) Applicant: MediaTek Inc., Hsin-Chu (TW)
(72) Inventor: Hsieh, Tung-Hsien, Changhua County Taiwan (TW); Chen, Nan-Cheng, Hsin-Chu City Taiwan (TW)
(74) Representative: Görz, Ingo

(57) **Abstract**

A wire bond chip package (100, 100a, 100b, 100c) includes a chip carrier (40, 140, 240); a semiconductor die (10) having a die face (10a) and a die edge (10c), the semiconductor die (10) being mounted on a die attach surface (40a, 140a) of the chip carrier, wherein a plurality of input/output (I/O) pads (12) are situated in or on the semiconductor die; a rewiring laminate structure (20) on the semiconductor die, the rewiring laminate structure comprising a plurality of redistribution bond pads (22); a plurality of bond wires (50) interconnecting the redistribution bond pads (22) with the chip carrier (40, 140, 240); and a mold cap (60) encapsulating at least the semiconductor die (10) and the bond wires (50).

## Description

This application claims the benefit of U. S. provisional application No. 61 /154,019 filed February 20, 2009.

The present invention relates to a wire bond chip package according to the precharacterizing clauses of claim 1.

As known in the art, there are a variety of chip package techniques such as ball grid array (BGA), wire bonding, flip-chip, etc. for mounting a die on a substrate via the bonding points on both the die and the substrate. In order to ensure miniaturization and multi-functionality of electronic products or communication devices, semiconductor packages are required to be of small in size, multi-pin connection, high speed, and high functionality.

Driven by growing demand for smaller, faster and cheaper electronic devices, the semiconductor industry continues to push inexpensive wire bonding technology to higher and higher levels. Nevertheless, for higher (input/output) I/O and higher clock speed the flip chip technology has become the technology of choice. This trend is reflected by that not only the majority of the microprocessors, but also high end ASICs and DSPs are being assembled today using flip chip technology. Still, the mainstream packages continue to be wire bonded - as the price advantages for devices with less than 500 I/O is significant. While the flip chip assembly benefits high performing devices, its cost is the major challenge for main stream applications. Thus, major efforts continue to be made to reduce costs.

Production cost, packaged device performance and overall size determine the choice between flip chip and wire bonding for IC interconnecting. The biggest advantage of wire bonding is its process flexibility and the sheer quantity of wire bonders in use today. As a consequence, it is a mature technology and the production process is thoroughly researched and well understood. Therefore, wire bonders are a commodity, unlike the advanced die attach platforms for flip chip bonding. In addition, the wire bonding technology is flexible. New package designs and tighter control of wire length in high frequency applications have further expanded the electrical performance range of wire bonded packages.

However, as the die size shrinks dramatically with the rapid advances in semiconductor manufacturing technologies in the last decade, seemingly, the I/O bond pad pitch on the die has reached the limits of the wire bonder. Therefore, there is a need in the industry for providing an improved package structure in order to extend the life of the wire bonding technology into next-generation technology nodes (e.g. under 55nm) and to cope with the problem of bond pad pitch limit arose from die shrink.

This in mind, the present invention aims at providing a novel wire bond chip package capable of extending the life of the wire bonding technology into next-generation technology nodes.

It is another objective to provide an improved wire bond chip package in order to cope with the problem of bond pad pitch limit arose from die shrink.

This is achieved by a wire bond chip package according to claim 1. The dependent claims pertain to corresponding further developments and improvements.

As will be seen more clearly from the detailed description below, the claimed wire bond chip package comprises a chip carrier; a semiconductor die having a die face and a die edge, the semiconductor die being mounted on a die attach surface of the chip carrier, wherein a plurality of input/output (I/O) pads are situated in or on the semiconductor die; a rewiring laminate structure on the semiconductor die, the rewiring laminate structure comprising a plurality of redistribution bond pads; a plurality of bond wires interconnecting the redistribution bond pads with the chip carrier; and a mold cap encapsulating at least the semiconductor die and the bond wires.

In one aspect, a wire bond chip package includes a chip carrier; a semiconductor die having a die face and a die edge, the semiconductor die being mounted on a die attach surface of the chip carrier, wherein a plurality of input/output (I/O) pads are situated in or on the semiconductor die; a support structure encompassing the semiconductor die; a rewiring laminate structure on the semiconductor die, the rewiring laminate structure comprising a plurality of redistribution bond pads; a plurality of bond wires interconnecting the redistribution bond pads with the chip carrier; and a mold cap encapsulating at least the semiconductor die, the rewiring laminate structure, the support structure and the bond wires.

In the following, the invention is further illustrated by way of example, taking reference to the accompanying drawings. Thereof:
FIG. 1 is a schematic plan view of an exemplary fan-out type wafer level package (WLP) in accordance with one embodiment of this invention.
FIG. 2 is a schematic, cross-sectional view of the fan-out type WLP taken along line I-I' of FIG. 1.
FIG. 3 is a flow diagram depicting the exemplary steps for manufacturing the fan-out WLP of FIG. 2.
FIG. 4 is a schematic, cross-sectional diagram showing another exemplary fan-out type WLP in accordance with another embodiment of this invention.
FIG. 5 is a schematic, cross-sectional diagram showing an exemplary wire bond chip package in accordance with yet another embodiment of this invention.
FIG. 6 is a schematic, cross-sectional diagram showing an exemplary wire bond chip package in accordance with yet another embodiment of this invention.
FIG. 7 is a schematic, cross-sectional diagram showing an exemplary wire bond chip package in accordance with yet another embodiment of this invention.
FIG. 8 is a schematic, cross-sectional diagram showing an exemplary wire bond chip package in accordance with yet another embodiment of this invention.
FIG. 9 and FIG.10 illustrate variants of the redistribution bond pad in cross-sectional views according to this invention.

In the following description, numerous specific details are given to provide a thorough understanding of the invention. However, it will be apparent to one skilled in the art that the invention may be practiced without these specific details. In order to avoid obscuring the present invention, some well-known system configurations and process steps are not disclosed in detail.

Likewise, the drawings showing embodiments of the apparatus are semi-diagrammatic and not to scale and, particularly, some of the dimensions are for the clarity of presentation and are shown exaggerated in the FIGS. Also, where multiple embodiments are disclosed and described having some features in common, for clarity and ease of illustration and description thereof like or similar features one to another will ordinarily be described with like reference numerals.

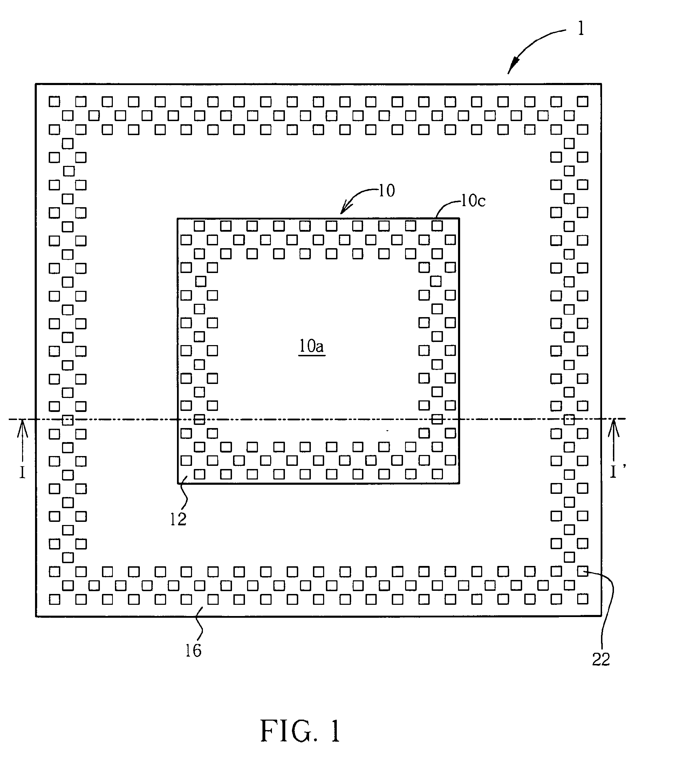

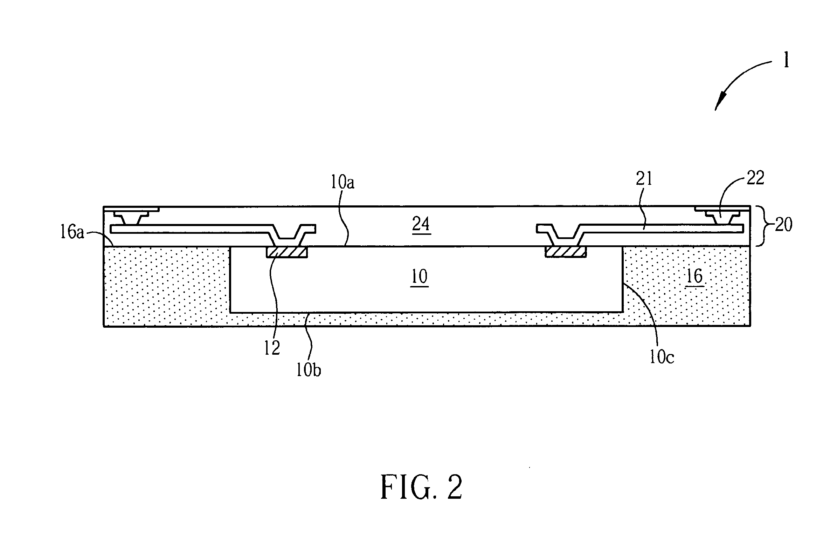

FIG. 1 is a schematic plan view of an exemplary fan-out type wafer level package (WLP) 1 in accordance with one embodiment of this invention. FIG. 2 is a schematic, cross-sectional view of the fan-out type WLP 1 taken along line I-I' of FIG. 1. As shown in FIG. 1 and FIG. 2, the fan-out type WLP 1 comprises a semiconductor die 10 having an active die face 10a and a backside surface 10b. A plurality of input/output (I/O) pads 12 are provided on the active die face 10 of the semiconductor die 10. As can be best seen in FIG. 1, the I/O pads 12 may be disposed along the four sides of the semiconductor die 10 in multiple rows, for example, three rows.

Of course, the number of rows of the I/O pads 12 is only for illustration purposes. For example, the I/O pads 12 may be arranged in two rows or in four rows in other embodiments. The I/O pads 12 are arranged on the active die face 10a in close proximity to each other with a tight pad pitch that may be beyond the limit of an advanced wire bonder. The present invention aims to cope with this problem arose from die shrink.

As can be best seen in FIG. 2, a support structure 16 may be provided to encompass the semiconductor die 10. Preferably, the support structure 16 comprises molding compounds. The support structure 16 may have a top surface 16a that is substantially flush with the active die face 10a. By way of example, the support structure 16 encapsulates the whole surfaces of the semiconductor die 10 except for the active die face 10a where the I/O pads 12 are formed.

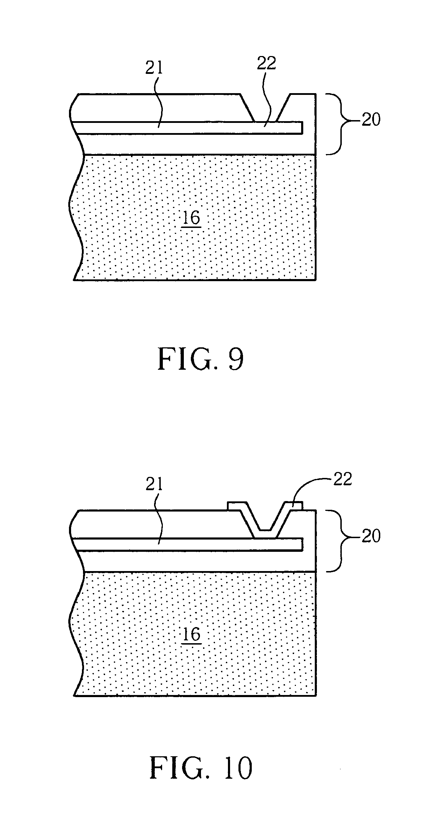

Still referring to FIG. 2, a rewiring laminate structure 20 is provided on the active die face 10a and also on the top surface 1 6a of the support structure 16. The rewiring laminate structure 20 comprises a re-routed metal layer 21 formed in a dielectric layer 24 such as silicon oxide, silicon nitride, polyimide, benzocyclobutane (BCB)-based polymer dielectric, a combination thereof, or any other suitable materials. The re-routed metal layer 21 may be made of copper, aluminum, a combination thereof, or any other suitable materials. The re-routed metal layer 21 in the rewiring laminate structure 20 redistributes the I/O pads 12 in or on the semiconductor die 10 to form redistribution bond pads 22 in or on the dielectric layer 24. According to one embodiment of this invention, the redistribution bond pads 22 may be made of copper, aluminum, titanium, nickel, vanadium, a combination thereof, or any other suitable materials. The I/O pads 12 may be made of copper, aluminum, a combination thereof, or any other suitable materials. It is to be understood that the sectional structure of the redistribution bond pads 22 as depicted through FIG. 2-8 are for illustration purposes only. Other configurations of the redistribution bond pads 22 providing coupling to the I/O pads 12 may be used. For example, FIG. 9 and FIG. 10 illustrate some variants of the redistribution bond pads 22, wherein the redistribution bond pad 22 may be a part of the re-routed metal layer 21 as shown in FIG. 9, or the in combination with other material layer as shown in FIG. 10.

According to the embodiment of this invention, the plurality of redistribution bond pads 22 may be arranged in multiple rows, for example, two or three rows, and the plurality of redistribution bond pads 22 may project beyond a die edge 10c of the semiconductor die 10. In another embodiment, only a portion of the redistribution bond pads 22 projects beyond the die edge 10c. In another embodiment, at least a portion of the redistribution bond pads 22 do not project beyond the die edge 10c. In yet another embodiment, there may not be redistribution bond pads 22 projecting beyond the die edge 10c. It is to be understood that the number of rows of the I/O pads 12 may be different from the number of rows of the redistribution bond pads 22. For example, the I/O pads 12 could be arranged in four rows while the redistribution bond pads 22 could be arranged in three rows.

According to another embodiment of this invention, the semiconductor die 10 may be a power management unit or a power IC, wherein some of the power or ground pads, which are arranged in an inner row on the active die face 10a, may be redistributed to the outer row or the outmost row of the multiple rows of the redistribution bond pads 22 on the dielectric layer 24 by way of the rewiring laminate structure 20. By doing this, the chip performance can be enhanced. In other words, with this invention, the pads may be redistributed to best accommodate package and performance requirements.

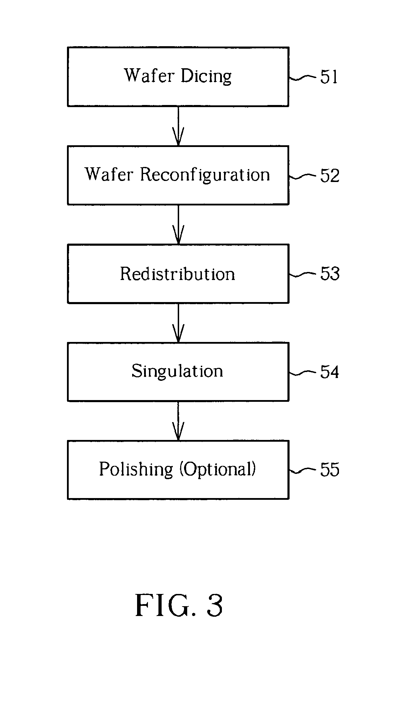

FIG. 3 is a flow diagram depicting the exemplary steps for manufacturing the fan-out WLP 1 of FIG. 2. As shown in FIG. 3, the fan-out WLP 1 of FIG. 1 can be manufactured by several stages including wafer dicing (Step 51), wafer reconfiguration (Step 52), redistribution (Step 53), and package singulation (Step 54). After the package singulation, optionally, a polishing process (Step 55) may be carried out to remove a portion of the molding compound, thereby exposing the backside surface 10b of the semiconductor die 10. Step 55 may be omitted if the backside surface 10b has been exposed during steps 51-54 or if it is decided not to be exposed. It is understood that the fan-out WLP can be manufactured by other methods. Different companies using redistribution technique implement the fan-out WLP using different materials and processes. Nonetheless, the steps required are somewhat similar.

Redistribution layer technique extends the conventional wafer fabrication process with an additional step that deposits a conductive rerouting and interconnection system to each device, e.g. chip, on the wafer. This is achieved using the similar and compatible photolithography and thin film deposition techniques employed in the device fabrication itself. This additional level of interconnection redistributes the peripheral contact pads of each chip to an area array of conductive pads that are deployed over the chip's surface.

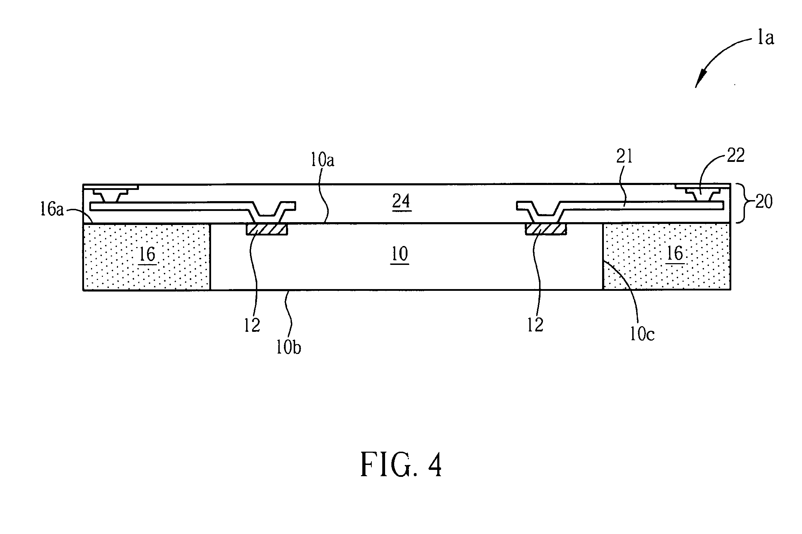

FIG. 4 is a schematic, cross-sectional diagram showing another exemplary fan-out type WLP 1a in accordance with another embodiment of this invention. As shown in FIG. 4, likewise, the fan-out type WLP 1a comprises a semiconductor die 10 having an active die face 10a and a backside surface 10b. A plurality of I/O pads 12 such as aluminum bond pads may be provided on the active die face 10a of the semiconductor die 10. The I/O pads 12 may be disposed along the four die edges 10c of the semiconductor die 10.

A support structure 16 could be provided to encompass the semiconductor die 10. Preferably, the support structure 16 may comprise molding compounds with good mechanical strength and superior adhesion ability to the semiconductor die 10. The support structure 16 may have a top surface 16a that is substantially flush with the die face 10a. In this embodiment, the support structure 16 merely covers the die edges 10c of the semiconductor die 10. The backside surface 10b is exposed and is not covered with the support structure 16.

Likewise, a rewiring laminate structure 20 is provided on the active die face 10a and on the top surface 16a of the support structure 16. The rewiring laminate structure 20 comprises a re-routed metal layer 21 formed in a dielectric layer 24. The re-routed metal layer 21 in the rewiring laminate structure 12 redistributes the I/O pads 12 in or on the semiconductor die 10 to form redistribution bond pads 22 in or on the dielectric layer 24.

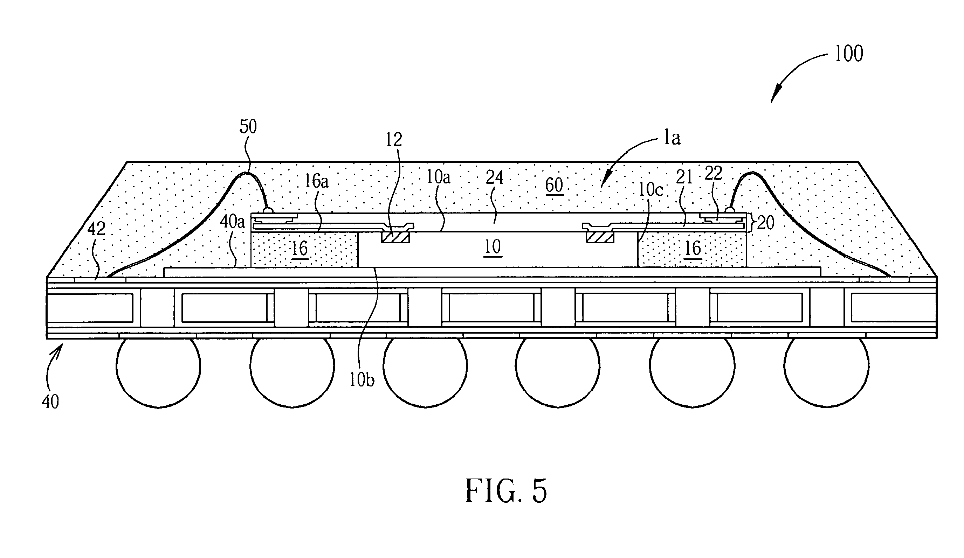

FIG. 5 is a schematic, cross-sectional diagram showing an exemplary wire bond chip package 100 in accordance with yet another embodiment of this invention. As shown in FIG. 5, a semiconductor die 10 having a die face 10a and a die edge 10c is mounted on a die attach surface 40a of a chip carrier 40 such as a package substrate or a printed circuit board, wherein a plurality of I/O pads 12 are situated in or on the semiconductor die 10. A support structure 16 may encompass the semiconductor die 10. The support structure 16 may have a top surface 1 6a that is substantially flush with the die face 10a.

A rewiring laminate structure 20 is provided on the semiconductor die 10. The rewiring laminate structure 20 comprises a plurality of redistribution bond pads 22 that may or may not project beyond the die edge 10c. A plurality of bond wires 50 are used to interconnect the redistribution bond pads 22 with the corresponding bond pads 42 on the chip carrier 40. A mold cap 60 may be provided to encapsulate at least the semiconductor die 10, the rewiring laminate structure 20, the support structure 16 and the bond wires 50. According to this embodiment, the mold cap 60 and the support structure 16 may be made of different molding compounds.

According to this embodiment, the bond wires 50 may comprise gold, copper, a combination thereof, or any other suitable materials. According to one embodiment of this invention, the redistribution bond pads 22 are made of copper and the bond wires 50 are copper wires.

Since the I/O pads 12 on the semiconductor die 10 with tighter pad pitches are redistributed to a peripheral, outer area that projects beyond the die edge 10c, the redistribution bond pads 22 thus have a looser pad pitch for wire bonding applications. However, as previously mentioned, the redistribution bond pads 22 may or may not project beyond the die edge 10c depending upon the design requirements.

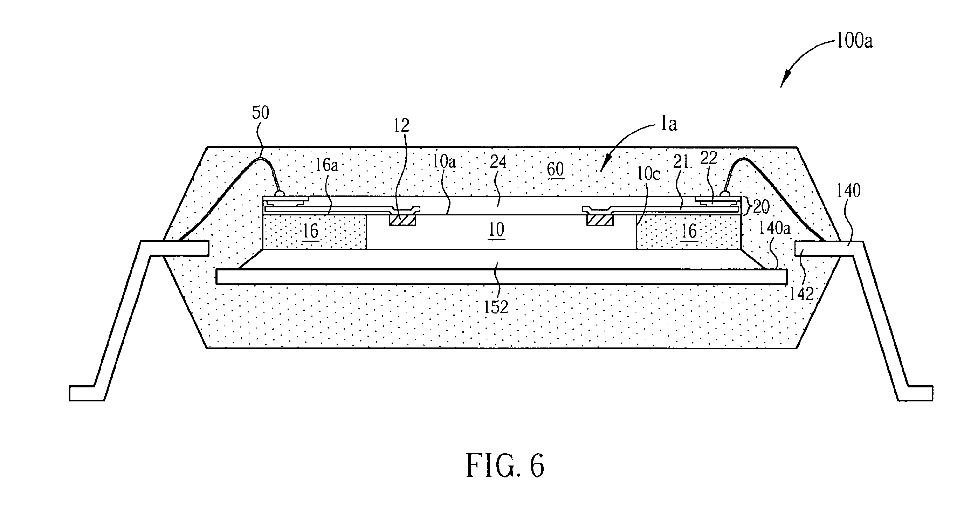

FIG. 6 is a schematic, cross-sectional diagram showing an exemplary wire bond chip package 100a in accordance with yet another embodiment of this invention. As shown in FIG. 6, a fan-out WLP 1 a including a semiconductor die 10 having a die face 10a and a die edge 10c is mounted on a die attach surface or die pad 140a of a chip carrier such as a leadframe 140 by an adhesive layer 152, wherein a plurality of I/O pads 12 are situated in or on the semiconductor die 10. The fan-out WLP 1 a may include a support structure 16 encompassing the semiconductor die 10. The support structure 16 may have a top surface 1 6a being substantially flush with the die face 10a.

The fan-out WLP 1 a further includes a rewiring laminate structure 20 that is fabricated on the semiconductor die 10 and on the top surface 16a of the support structure 16. The rewiring laminate structure 20 may be fabricated in an assembly house. The rewiring laminate structure 20 comprises a plurality of redistribution bond pads 22 that may project beyond the die edge 10c and the redistribution bond pads 22 may have a looser pad pitch for wire bonding applications. In another embodiment, depending upon the design requirements, the redistribution bond pads 22 may not project beyond the die edge 10c, or only a portion of the redistribution bond pads 22 project beyond the die edge 10r. In yet another embodiment, at least a portion of the redistribution bond pads 22 do not project beyond the die edge 10c.

A plurality of bond wires 50 are used to interconnect the redistribution bond pads 22 with the corresponding inner leads 142 of the leadframe 140. A mold cap 60 may be provided to encapsulate at least the semiconductor die 10, the rewiring laminate structure 20, the support structure 16, the die pad 140a, the inner leads 142 and the bond wires 50. According to this embodiment, the bond wires 50 may comprise gold, copper, a combination thereof, or any other suitable materials.

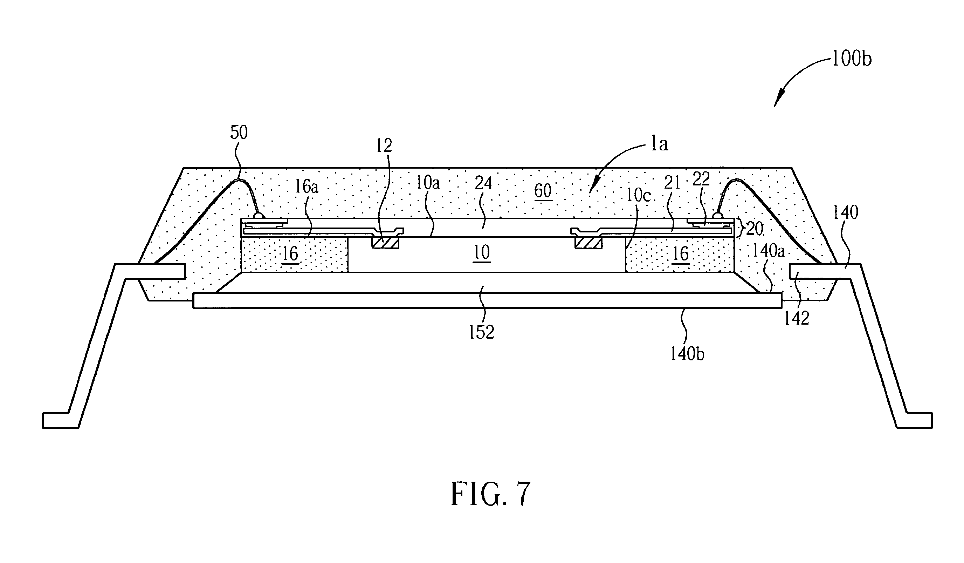

FIG. 7 is a schematic, cross-sectional diagram showing an exemplary wire bond chip package 100b in accordance with yet another embodiment of this invention. As shown in FIG. 7, a fan-out WLP 1 a including a semiconductor die 10 having a die face 10a and a die edge 10c is mounted on a die pad 140a of a leadframe 140 by an adhesive layer 152, wherein a plurality of I/O pads 12 are situated in or on the semiconductor die 10. The fan-out WLP 1 a may include a support structure 16 encompassing the semiconductor die 10. The support structure 16 may have a top surface 16a being substantially flush with the die face 10a. The fan-out WLP 1 a further includes a rewiring laminate structure 20 provided on the semiconductor die 10 and on the top surface 16a of the support structure 16. Likewise, the rewiring laminate structure 20 comprises a plurality of redistribution bond pads 22 that may or may not project beyond the die edge 10c.

A plurality of bond wires 50 are used to interconnect the redistribution bond pads 22 with the corresponding inner leads 142 of the leadframe 140. The bond wires 50 may comprise gold, copper, a combination thereof, or any other suitable materials. A mold cap 60 may be provided to encapsulate at least the semiconductor die 10, the rewiring laminate structure 20, the support structure 16, the inner leads 142 and the bond wires 50. According to this embodiment, a bottom surface 140b of the die pad 140a is not encapsulated by the mold cap 60 and is thus exposed to air. Such package configuration can be referred to as an exposed-pad (E-pad) low-profile quad flat package (LQFP).

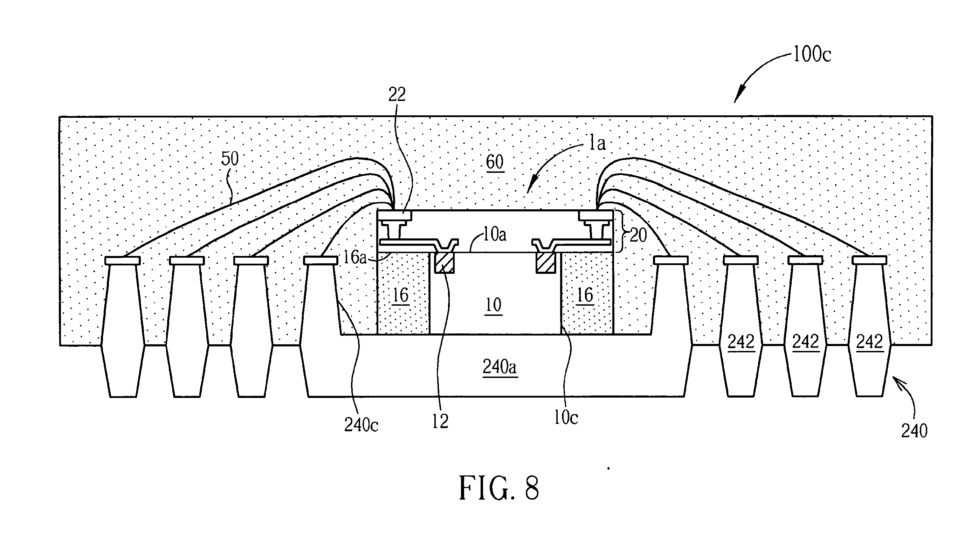

FIG. 8 is a schematic, cross-sectional diagram showing an exemplary wire bond chip package 100c in accordance with yet another embodiment of this invention. As shown in FIG. 8, a fan-out WLP 1 a including a semiconductor die 10 having a die face 10a and a die edge 10c is mounted on a die pad 240a of a leadframe 240, wherein a plurality of I/O pads 12 are situated in or on the semiconductor die 10. The die pad 240a may further include a recess 240c and the semiconductor die 10 may be mounted within the recess 240c. The fan-out WLP 1 a may include a support structure 16 encompassing the semiconductor die 10. The support structure 16 may have a top surface 16a being substantially flush with the die face 10a. The fan-out WLP 1 a further includes a rewiring laminate structure 20 provided on the semiconductor die 10. The rewiring laminate structure 20 comprises a plurality of redistribution bond pads 22 that may or may not project beyond the die edge 10c.

A plurality of bond wires 50 are used to interconnect the redistribution bond pads 22 with the corresponding interconnection pads 242 of the leadframe 240. The bond wires 50 may comprise gold, copper, a combination thereof, or any other suitable materials. A mold cap 60 may be provided to encapsulate at least the semiconductor die 10, the rewiring laminate structure 20, the support structure 16, the upper portion of the die pad 240a, the upper portion of the interconnection pads 242 and the bond wires 50. The package configuration as depicted in FIG. 8 can be referred to as a quad flat non-leaded (QFN) package or an advanced QFN (aQFN) package.

In other embodiments, the support structure 16 shown in FIGS. 2 and 4-10 may be omitted. In yet other embodiments, there may be another semiconductor die on or over the semiconductor die 10. The another semiconductor die may be coupled to the semiconductor die 10 by at least a bond wire. In yet other embodiments, the another semiconductor die may be coupled to a redistribution bond pads 22 of the semiconductor die 10 that does not project beyond the die edge 10c.

## Claims

1. A wire bond chip package (100, 100a, 100b, 100c), comprising:
a chip carrier (40, 140, 240);
a semiconductor die (10) mounted on a die attach surface (40a, 140a) of the chip carrier (40, 140, 240), wherein a plurality of input/output (I/O) pads (12) are situated in or on the semiconductor die (10);
a rewiring laminate structure (20) on the semiconductor die (10), the rewiring laminate structure (20) comprising a plurality of redistribution bond pads (22);
a plurality of bond wires (50) interconnecting the redistribution bond pads (22) with the chip carrier (40, 140, 240); and
a mold cap (60) encapsulating at least the semiconductor die (10) and the bond wires (50).

2. The wire bond chip package (100, 100a, 100b, 100c) according to claim 1 wherein the chip carrier (40) is a package substrate.

3. The wire bond chip package (100, 100a, 100b, 100c) according to claim 1 wherein the chip carrier (40) is a printed circuit board.

4. The wire bond chip package (100, 100a, 100b, 100c) according to claim 1 wherein the chip carrier (140, 240) is a leadframe.

5. The wire bond chip package (100, 100a, 100b, 100c) according to claim 4 wherein the wire bond chip package is a low-profile quad flat package (LQFP).

6. The wire bond chip package (100, 100a, 100b, 100c) according to claim 4 wherein the wire bond chip package is a quad flat non-leaded (QFN) package.

7. The wire bond chip package (100, 100a, 100b, 100c) according to claim 1 wherein the bond wires (50) are gold wires.

8. The wire bond chip package (100, 100a, 100b, 100c) according to claim 1 wherein the bond wires (50) are copper wires.

9. The wire bond chip package (100, 100a, 100b, 100c) according to claim 1 wherein at least one of the redistribution bond pads (22) project beyond the die edge (1 0c) of the semiconductor die (10).

10. The wire bond chip package (100, 100a, 100b, 100c) according to claim 1 , further comprising:
a support structure (16) encompassing the semiconductor die (10);
wherein the mold cap (60) encapsulates at least the semiconductor die (10), the rewiring laminate structure (20), the support structure (16) and the bond wires (50).

11. The wire bond chip package (100, 100a, 100b, 100c) according to claim 10 wherein a top surface (1 6a) of the support structure (16) is substantially flush with a die face (10a).

12. The wire bond chip package (100, 100a, 100b, 100c) according to claim 11 wherein the rewiring laminate structure (20) is also formed on the top surface (16a) of the support structure (16).

13. The wire bond chip package (100, 100a, 100b, 100c) according to claim 10 wherein the support structure (16) and the mold cap (60) are made of different molding compounds.

14. The wire bond chip package (100, 100a, 100b, 100c) according to claim 10 wherein material of the I/O pads (12) comprises copper, aluminum or a combination thereof..

15. The wire bond chip package (100, 100a, 100b, 100c) according to claim 10 wherein material of the redistribution bond pads (22) comprises copper, aluminum, titanium, nickel, vanadium or a combination thereof.
